# EUROPEAN PATENT APPLICATION

(11) **EP 4 686 366 A1**
(43) Date of publication of application: **28.01.2026**
(21) Application number: 24191054.6
(22) Date of filing: 26.07.2024
(51) Int. Cl.: H10K 85/30, H10K 50/16, H10K 50/17

(54) **THE USE OF QUINOLIN-8-OLATE DERIVATIVES AND A DEVICE COMPRISING THE SAME**

(71) Applicant: Noctiluca S.A., 87-100 Torun (PL)
(72) Inventor: Barkowski, Patrick, 01067 Dresden (DE); Bosiak, Mariusz, 87-148 Papowo Torunskie (PL); Dalgleish, Simon, 12169 Berlin (DE); Glodek, Marta, 95-035 Ozorkow (PL); Kamata, Takahiro, 10439 Berlin (PL)
(74) Representative: Kowalkiewicz, Zuzanna

(57) **Abstract**

The subject of the invention is a new use of a compound as a compound intermediating a transport or injection of electrons in an electroluminescent device, an electron injecting layer comprising the compound, an electron transport layer comprising the compound and an electroluminescent device comprising the compound. The electroluminescent device comprises an anode, cathode, and the compound disposed between the anode and cathode. The present invention belongs to the field of light-emitting diodes/devices.

## Description

### FIELD

The present disclosure generally relates to the use of quinolin-8-olate derivatives, an electron injecting material, electron transport layer, and an electroluminescent device, and a photovoltaic cell comprising the same. The invention belongs to the field of light-emitting diodes/devices.

### BACKGROUND

Electroluminescent devices comprise organic light-emitting diodes (OLED) that are also described as organic light-emitting devices in the state of the art. OLED comprise two electrodes, between which there are organic or organometallic layers, of which at least one is an emissive layer containing at least one chemical compound - an emitter. Electroluminescent devices and photovoltaic cells also comprise an electron injecting layer containing an electron injecting material, and an electron transfer layer containing electron transfer material.

The electron injecting layer (EIL) and electron transport layer (ETL) are crucial to the functionality of electroluminescent devices such as OLED and other optoelectronic devices. The stability and characteristics of the materials comprising these layers have a fundamental impact on the device's current efficiency, operational lifespan, and overall performance.

The electron injecting layer is crucial for enabling the injection of electrons from the cathode into the electron transport layer. Common materials used in the EIL include low work function metals like calcium (Ca) or lithium fluoride (LiF), organometallic compounds such as 8-quinolinolato lithium (Liq), and other organic materials such as polyethyleneimine (PEI).

The electron transport layer (ETL) plays an essential role in transporting electrons from the EIL to the emissive layer, where they recombine with holes to emit light. Typical materials for the ETL include organic molecules like tris(8-hydroxyquinolinato)aluminium (Alq3) and inorganic materials such as zinc oxide (ZnO).

Low-work function materials are commonly utilized in the electron injecting layer to enhance electron injection. However, these materials can be chemically reactive and susceptible to degradation, which can impact their stability. Organic materials, while offering flexibility and reduced costs, may have lower stability compared to inorganic materials such as metal oxides. A hybrid approach, combining organic and inorganic materials, can sometimes provide enhanced stability and performance by leveraging the advantages of both types of materials.

The materials used in the electron injecting layer and electron transport layer must exhibit high electron mobility and appropriate energy alignment to facilitate efficient electron injection and transport. Poor stability in these materials can result in increased resistance and lower electron mobility, thereby diminishing current efficiency. The stability of EIL and ETL materials is also crucial for the longevity of optoelectronic devices such as OLED and photovoltaic cells. Materials that degrade under operational conditions, such as exposure to moisture, oxygen, or thermal stress, can lead to device failure. Contrarily, stable materials ensure consistent performance over time, thereby extending the device's lifetime. Efficient charge injection and transport minimize energy losses and enhance overall device efficiency. Additionally, materials with high thermal and chemical stability prevent the formation of defects that could act as non-radiative recombination centres, which would otherwise reduce efficiency.

One object of the disclosure is to provide a new use of quinoline-8-olate derivative as a compound intermediating a transport or injection of electrons in an electroluminescent device, that can better withstand operational stresses and environmental factors, thus enhancing device performance and durability. The subsequent objective of the disclosure is to provide an electron injecting layer comprising the compound and an electron transfer layer comprising the compound. The third objective of the invention is to provide an electroluminescent device having an increased efficiency and operational lifetime, which comprises the compound.

### SUMMARY OF THE INVENTION

The present invention relates to the use of **Compound 1** or **Compound 2** as a compound intermediating a transport or injection of electrons in an electroluminescent device, wherein **Compound 1** and **Compound 2** are:

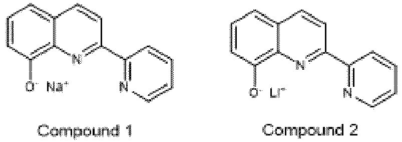

An electron injecting layer comprises **Compound 1** or **Compound 2.**

An electron transport layer comprises **Compound 1** or **Compound 2**
An electroluminescent device comprising an anode, cathode, and **Compound 1** and/or **Compound 2** disposed between the anode and cathode.

In a preferred embodiment of the invention, wherein the electron injecting layer is according to the invention, and/or the electron transport layer is according to the invention.

In a preferred embodiment of the invention, wherein comprises at least one layer selected from: a hole injection layer, hole transport layer, electron blocking layer, hole blocking layer, and emissive layer.

One of the significant issues associated with electron transport material and electron injection material present in electroluminescent devices is their structure and inter- and/or intramolecular interactions. The structure of the EIL and ETL material impacts the lifespan of electroluminescent devices. A well-optimized structure enhances electron injection and transport of electrons, thus reducing the driving voltage, minimizing energy losses, and slowing down the device's degradation process. Moreover, structural properties such as crystallinity, presence of defects, and stability also influence the durability of electroluminescent devices. Another critical feature involves the thickness of the electron injection layer. For some currently used compounds, as the thickness of the EIL increases, the driving voltage also increases. This influences the efficiency of the device, which can be highly sensitive to the precise thickness of these layers. Conventional EIL materials such as Liq (8-quinolinolato lithium) possess lower stability and devices containing such exhibit shorter lifetime, indicating a quicker degradation of the device. Another crucial factor is that Liq layer requires precise thickness control to ensure effective electron transport and injection.

Unexpectedly, **Compound 1** and **Compound 2** used as electron transport and/or electron injecting material may improve the lifetime of the electroluminescent device and its general efficiency. The structures of **Compound 1** and **Compound 2** exhibit high crystallinity with strong π-π interactions which may lead to well-ordered films and thus enhance electron transport and electron injection efficiency in the device. The high crystallinity of the compounds was confirmed by single-crystal XRD and powder XRD methods. The crystallographic parameters of **Compound 1** are presented in **Table 3.**

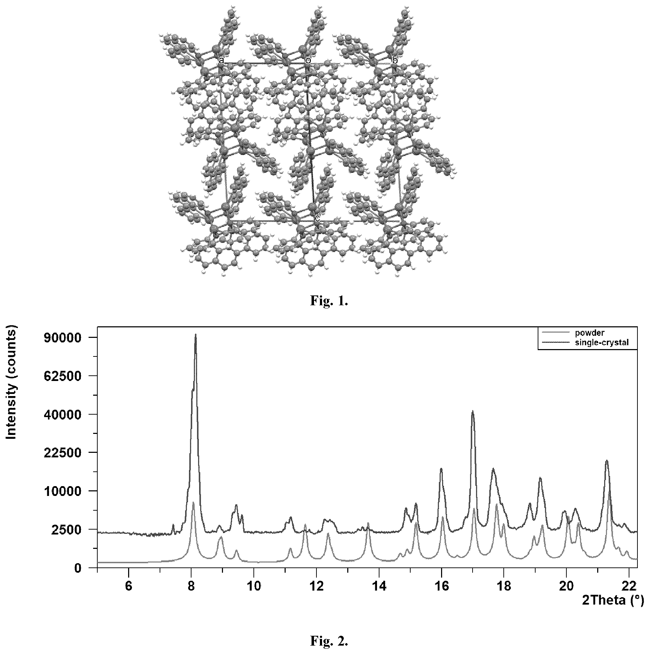

The core of the crystal structure of **Compound 1** is a Na₄O₄ cube consisting of alternately arranged sodium and oxygen atoms. The sodium ion is pentacoordinated, bonded coordinatively to three oxygen atoms and two nitrogen atoms. The compounds exhibit excellent diffraction, as indicated by the R₍ᵢₙₜ₎ factor equal to 0.0244. R₁ parameter is close to 0, with a value of 0.0678, indicating that the crystallographic model confirms this structure. The Δρ max parameter is 0.489 (i.e., less than half electron), confirming the completeness of the model and it seems as it lacks significant defects in this lattice. **Figure 1** shows the crystal lattice of **Compound 1** along the [1-10] direction. The parallel arrangement of the rings indicates the presence of π-π interactions. π-π stacking interactions and edge-to-face interactions are observed, which facilitate electron transport and transfer in the device.

Additionally, it appeared that the structure has no significant structure defects or aggregates ensuring the uniform electron distribution. Such aggregates and defects may trap electrons and thus lower the conductivity. Additionally, the use of **Compound 1** and **Compound 2** does not result in the formation of aggregates or electron traps, thus no energy losses are present. The examined **Compound 1** is pure, as confirmed by comparing the single-crystal and powder diffractograms (**Figure 2**). There are only minor discrepancies in peak matching, related to different temperatures of the measurements and thus lattice stresses. Furthermore, the structure of the compounds does not have significant lattice defects, as confirmed by the diffractogram (narrow, high intensity peaks, high peak-to-noise ratio).

The use of **Compound 1** and **Compound 2** as electron transfer and/or electron injection material may thus extend the lifespan of the device significantly, without other changes in the photophysical properties of the device.

### GENERAL DEFINITION OF TERMS AND SUBSTITUENTS

As used herein, the terms "or" and "and/or" include any and all combinations of one or more of the associated listed items. The term "or" is not an exclusive term, e.g., A or B means A, B, or A and B. The expression "at least one" comprises at least one, two, three, four, five, and more mentioned elements (etc.).

It should be understood that the terms "comprises," "comprising," "includes," "including," "has", "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

### BRIEF DESCRIPTION OF THE FIGURES

**Fig. 1****.** Crystal structure of **Compound 1** (view 1-1-0).
**Fig. 2****.** Single-crystal and powder diffractograms of **Compound 1.**

### DETAILED DESCRIPTION OF THE INVENTION

The present invention is illustrated by the following examples in detail.

### Example 1: Quinolin-8-olate derivatives compounds

The quinolin-8-olate derivative compound can be:

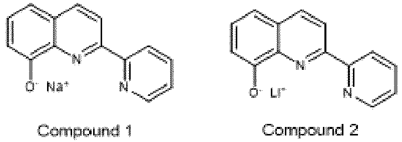

### Example 2: Process for obtaining Compound 1 and Compound 2

The processes of obtaining **Compound 1** and **Compound 2** are presented in the following examples, which do not limit its scope of protection.

### 2.1. Process for the preparation of sodium 2-(pyridin-2-yl)quinolin-8-olate (Compound 1) by a three-step synthesis

### a. Synthesis of 8-methoxy-2-(pyridin-2-yl)quinoline (intermediate 1.1)

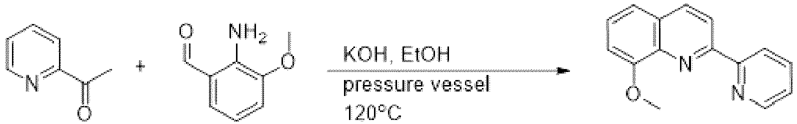

2-amino-3-methoxybenzaldehyde (30 g, 0.2 mol) in 100 ml absolute ethanol, 2-acetylpyridine (24.5 g, 0.21 mol), and potassium hydroxide are added into a pressure bottle and kept stirring at 120° C overnight. Then, the crude mixture was allowed to cool down to room temperature and concentrated using a rotary evaporator. The concentrated crude was wholly dissolved in dichloromethane at ambient temperature. Then, transferred to a separation funnel and treated with 1M hydrochloric acid until neutral pH, followed by extraction using an excess amount of dichloromethane. After drying over anhydrous magnesium sulphate, the mixture was concentrated and obtained a brown solid (42 g, Yield: 90%) as an expected intermediate.
**1.1:** ¹H NMR (400 MHz, CDCl₃) 8.73-8.70 (m, 2H), 8.60 (d, 1H, J = 8.6 Hz), 8.26 (d, 1H, J = 8.6 Hz), 7.89-7.84 (m, 1H), 7.50-7.42 (m, 2H), 7.36-7.32 (m, 1H), 7.08 (dd, 1H, J = 7.5, 1.5 Hz), 4.13 (s, 3H)

### b. Synthesis of 2-(pyridin-2-yl)quinolin-8-ol (intermediate 1.2)

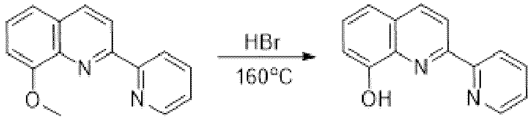

To a pressure vessel was added 8-(methoxy-2-pyridin-2-yl)quinoline (42 g, 0.18 mol) and dissolved in 100 ml of hydrobromic acid (48%). The mixture was stirred at 160° C overnight. Then, the reaction was allowed to cool, and water was added. The obtained yellow solid was filtered, suspended in dichloromethane, and washed with NaHCO₃. The combined organic layers were dried over MgSO₄ and concentrated in vacuo. The crude solid was purified via MPLC eluting with 95:5 dichloromethane:ethyl acetate to give a light-yellow solid (34 g, 86 %).
**1.2:** ¹H NMR (700 MHz, DMSO-d₆) 9.80 (s, 1H), 9.09 (d, 1H, J = 8.2 Hz), 8.74-8.73 (m, 1H), 8.59 (d, 1H, J = 8.6 Hz), 8.44 (d, 1H, J = 8.6 Hz), 8.02-8.00 (m, 1H), 7.51-7.42 (m, 3H), 7.15 (dd, 1H, J = 7.5, 1.2 Hz)

### c. Synthesis of sodium 2-(pyridin-2-yl)quinolin-8-olate (Compound 1)

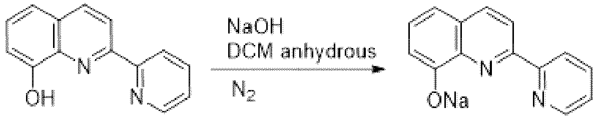

To the solution of 2-(pyridin-2-yl)quinolin-8-ol (10 g, 45 mmol) in 100 ml of anhydrous dichloromethane was added sodium hydroxide (1.8 g, 45 mmol) under nitrogen atmosphere. The mixture was stirred at room temperature for 24 hours. The precipitate was filtered, washed with dichloromethane, and dried in vacuo. The yellow solid (10.5 g, 95 %) was stored under an inert atmosphere.
**Compound 1:** ¹H NMR (700 MHz, DMSO-d₆) 8.58 (d, 1H, J = 4 Hz), 8.38 (d, 1H, J = 7.8 Hz), 8.10 (s, 2H), 7.83 (t, 1H, J = 7.8 Hz), 7.37-7.35 (m, 1H), 7.17 (t, 1H, J = 7.8 Hz), 6.53 (d, 1H, J = 7.8 Hz), 6.48 (d, 1H, J = 7.9 Hz)

### 2.2. Process for the preparation of litium 2-(pyridin-2-yl)quinolin-8-olate (Compound 2).

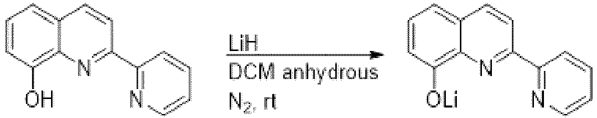

To the solution of 2-(pyridin-2-yl)quinolin-8-ol (666 mg, 3 mmol) in 8 ml of anhydrous dichloromethane was added lithium hydride (24 mg, 3 mmol) under nitrogen atmosphere. The mixture was stirred at room temperature for 24 hours. The precipitate was filtered, washed with dichloromethane, and dried in vacuo. The yellow solid (421 mg g, 62%) was stored under an inert atmosphere.
**Compound 2:** ¹H NMR (400 MHz, DMSO-d₆) 8.62 (bs, 1H, J = 4 Hz), 8.52 (d, 1H, J = 8.0 Hz), 8.18 (d, 2H, J = 5.9 Hz), 7.71 (bs, 1H), 7.35 (t, 1H, J = 6.0 Hz), 7.22 (t, 1H, J = 7.8 Hz), 6.60 (d, 1H, J = 7.7 Hz), 6.51 (d, 1H, J = 7.4 Hz)

### Example 3: A diode comprising Compound 1

The electroluminescent device comprises an anode, cathode, and **Compound 1** and **Compound 2** disposed between the anode and cathode. The electroluminescent device, i.e. diode, can comprise an electrode 1 and electrode 2 that can be made of aluminum (Al) and ITO. The diode can comprise at least one layer, i.e. electron transport layer comprising **Compound 1** and **Compound 2** and/or electron injection layer comprising **Compound 1** and **Compound 2.** Constructed exemplary diodes 1 (reference), 2, and 3 comprise ITO, HATCN as HIL, PCBBiF as HTL, PCzAc as EBL, 2CzPy: 20% 4CzIPN as an emissive layer, DDBFT as HBL and BPPB:**Compound 1** (2:1) as ETL. Reference diode 1 comprises Liq as EIL and diodes 2 and 3 comprises **Compound 1** as EIL. Constructed exemplary diodes 4 (reference), 5, and 6 comprise ITO, HATCN as HIL, PCBBiF as HTL, DPFAn:5% BD-06 as an emissive layer, and BPPB:**Compound 1** (2:1) as ETL. Reference diode 4 comprises Liq as EIL and diodes 5 and diode 6 comprises **Compound 1** as EIL. Exemplary electroluminescent diodes are presented in **Table 1.**

**Table 1. Exemplary electroluminescent diodes according to the invention are presented**

| **No. of diode** | **Anode layer** | **HIL** | **HTL** | **EBL** | Emissive **layer (weight ratio)** | **HBL** | **ETL (weight ratio)** | **EIL** | **Cathode layer** |
|---|---|---|---|---|---|---|---|---|---|
| ***1. Ref.*** | ITO | HATCN | PCBBiF | PCzAc | 2CzPy: 20% 4CzIPN | DDBFT | BPPB: **Comp. 1** (2:1) | Liq 1.5 nm | Al |
| **2.** | ITO | HATCN | PCBBiF | PCzAc | 2CzPy: 20% 4CzIPN | DDBFT | BPPB: **Comp. 1** (2:1) | Comp. 1 1.0 nm | Al |
| **3.** | ITO | HATCN | PCBBiF | PCzAc | 2CzPy: 20% 4CzIPN | DDBFT | BPPB: **Comp. 1** (2:1) | Comp. 1 1.5 nm | Al |
| **4. *Ref.*** | ITO | HATCN | PCBBiF | - | DPFAn: 5% BD-06 | - | BPPB: **Comp. 1** (2:1) | Liq 1.5 nm | Al |
| **5.** | ITO | HATCN | PCBBiF | - | DPFAn: 5% BD-06 | - | BPPB: **Comp. 1** (2:1) | Comp. 1 1.0 nm | Al |
| **6.** | ITO | HATCN | PCBBiF | - | DPFAn: 5% BD-06 | | BPPB: **Comp. 1** (2:1) | Comp. 1 1.5 nm | Al |

| | | | | | | | | | |
|---|---|---|---|---|---|---|---|---|---|
| Abbreviations: ITO - indium tin oxide; HIL - hole injection layer; HTL - hole transport layer; EBL - electron blocking layer; HBL - hole blocking layer; ETL - electron transport layer; EIL - electron injection layer; Comp. - compound. | | | | | | | | | |

The compounds used in exemplary diodes presented in **Table 1** are:

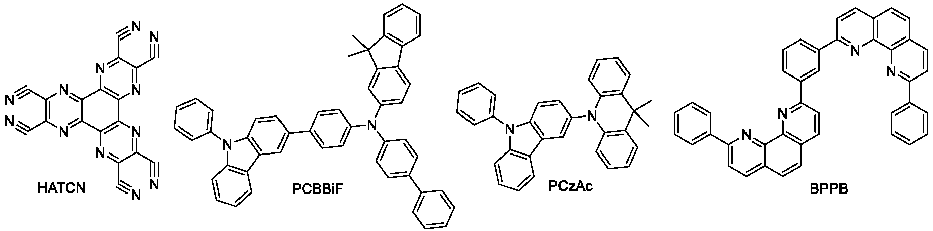

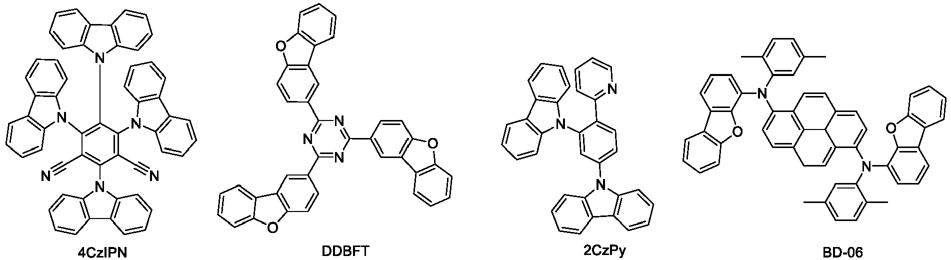

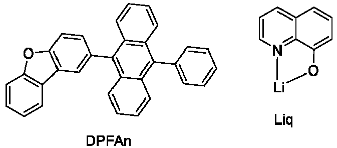

**Compound 1** and **Compound 2** are characterized by high crystallinity, confirmed by XRD measurements (**Table 3**), and strong π-π interactions, both π-π stacking and edge-to-face, which lead to well-ordered films in the EIL and ETL and thus enhance electron transport and electron injection efficiency in the device, leading to a significantly longer lifetime of the electroluminescent device. No significant defects of the crystal structure are present, thus no local temperature increase occurs in the ETL and EIL and no electron traps appear. This has a significant effect on the prolonged lifetime of the device. Reference diode 1 comprising Liq as an electron injection material exhibits a shorter lifetime (LT₉₀ = 16 h) than analogous diodes 2 (LT₉₀ = 56 h) and 3 (LT₉₀ = 65 h) comprising **Compound 1** as electron injection material. Diodes 5 and 6 comprising **Compound 1** as an electron injection material show an even longer lifetime (LT₉₀ = 110.2 h and 122.5, respectively) than reference diode 4 (LT₉₀ = 8 h). At the same time, current-spectral properties (i.e. V_{ON}, EQE, C.E., ELₘₐₓ, FWHM, CIE) of such devices are not significantly changed. Exemplary current-spectral measurements for exemplary electroluminescent diodes are presented in **Table 2.**

**Table 2. Current-spectral measurements for the diodes according to the invention**

| **No. of diode** | **Vₒₙ @1 cd/m² [V]** | **EQE (max/5 000 cd/m²) [%]** | **C.E. (max/1 000 cd/m²/5 000 cd/m²) [cd/A]** | **ELₘₐₓ [nm]** | **FWHM [nm]** | **LT₉₀ (@1 000nits/ 5 000 nits) [h]** | **Colour coordinates CIE [x/y]** |
|---|---|---|---|---|---|---|---|
| **1. Ref.** | 3.3 | 20.7/18.4 | 59.2/-/52.7 | 539 | 91 | -/16 | 0.38/0.57 |
| **2.** | 3.2 | 16.1/15.3 | 46.0/-/44.1 | 545 | 94 | -/56 | 0.39/0.56 |
| **3.** | 3.2 | 18.2/16.2 | 51.6/- 46.4 | 544 | 97 | -/65 | 0.39/0.57 |
| **4. Ref.** | 2.67 | 7.96/7.72 | 7.22/7.17/- | 457 | 45 | 8/- | 0.14/0.12 |
| **5.** | 2.67 | 8.03/7.72 | 7.36/7.17/- | 457 | 44 | 110.2/- | 0.14/0.13 |
| **6.** | 2.67 | 8.51/8.37 | 7.62/7.58/- | 457 | 44 | 122.5/- | 0.14/0.12 |

| | | | | | | | |
|---|---|---|---|---|---|---|---|
| Abbreviations: Ref. - reference diode; Vₒₙ - turn-on voltage; EQE - external quantum efficiency; C.E. - current efficiency; ELₘₐₓ - a maximum wavelength of the diode emission; FWHM - full width at half maximum; LT₉₀ - operational lifetime of diode, wherein luminance decreases to 90% of the original; CIE - CIE 1931 colour spaces. | | | | | | | |

In **Table 3** crystallographic parameters of **Compound 1** are presented. The single-crystal XRD method confirms monoclinic crystal system and Cc space group of **Compound 1** with low R1 parameter (0.0878). R₍ᵢₙₜ₎ factor is low, thus confirming high crystallinity. No significant structure defects are confirmed by Δρ max parameter equal to 0.489, which is less than one electron. This characteristic influences the prolonged device lifetime.

**Table 3. Crystallographic parameters of Compound 1**

| **T [K]** | **A [Å]** | **Crystal system** | **Space group** | **UCD** | **Ind. refl.** | **Ref.** | **R indices** | **Δρ max, Δρ max [eÅ⁻³]** |
|---|---|---|---|---|---|---|---|---|
| 100 | 1.54184.4 | monoclinic | Cc | a=15.9006 Å | 6460 R₍ᵢₙₜ₎=0.0244 | Full-matrix least-squares on F2 | R1=0.0878 | 0.489 and -0.795 |
| | | | | α=90° | | | | |
| | | | | b=15.1699 Å | | | | |
| | | | | β=95.095° | | | | |
| | | | | c=19.9635 Å | | | | |
| | | | | v=90° | | | | |

| | | | | | | | | |
|---|---|---|---|---|---|---|---|---|
| Abbreviations: T - temperature of the measurement; Λ - wavelength; UCD - unit cell dimensions; Ind. refl. - independent reflections; R₍ᵢₙₜ₎ - reliability factor; Ref. - refinement method; Δρ max, Δρ max - largest difference peak and hole. | | | | | | | | |

## Claims

1. The use of Compound 1 or Compound 2 as a compound intermediating a transport or injection of electrons in an electroluminescent device, wherein Compound 1 and Compound 2 are:

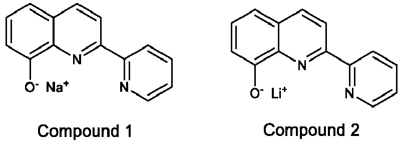

2. An electron injecting layer comprises Compound 1 or Compound 2.

3. An electron transport layer comprises Compound 1 or Compound 2.

4. An electroluminescent device comprising an anode, cathode, and Compound 1 or/and Compound 2 disposed between the anode and cathode.

5. The device according to claim 4, wherein the electron injecting layer is according to claim 2, or/and the electron transport layer is according to claim 3.

6. The device according to claim 4 or 5, wherein comprises at least one layer selected from: a hole injection layer, hole transport layer, electron blocking layer, hole blocking layer, and emissive layer.
